# EUROPEAN PATENT SPECIFICATION

(11) **EP 1 583 143 B1**
(45) Date of publication and mention of the grant of the patent: **05.10.2011**
(21) Application number: 05003842.1
(22) Date of filing: 23.02.2005
(51) Int. Cl.: H01L 21/336, H01L 29/786

(54) **Method of fabricating self-aligned source and drain contacts in a Double gate FET with controlled manufacturing of a thin Si or non-Si channel**
Methode zur Herstellung von selbst-justierten Source/Drain-Kontakten in einem Doppel-Gate-FET unter kontrollierter Herstellung eines dünnen Si- oder Nicht-Si-Kanals
Méthode pour la fabrication de contacts source/drain auto-alignés dans un FET à double grille avec un contrôle du procédé de fabrication d'un canal mince avec ou sans silicium

(30) Priority: 29.03.2004 EP 04101291
(43) Date of publication of application: 05.10.2005
(73) Proprietor: IMEC, 3001 Leuven (BE); NXP B.V., 5656 AG Eindhoven (NL)
(72) Inventor: Ponomarev, Youri V., 3001 Leuven (BE); Loo, Josine Johanna Gerarda Petra, 3001 Leuven (BE)
(74) Representative: Bird, Ariane

(56) References cited:
- WO-A-03/083934
- JP-A- 2003 309 267
- US-B1- 6 214 693

## Description

The present invention relates to a method of fabricating a transistor structure as defined in claim 1.

Also, the present invention relates to a FET comprising such source and drain contacts and such a channel region. Furthermore, the present invention relates to a semiconductor device comprising such a FET.

US 6,458,662 B1 discloses a method of fabricating a dual gate MOSFET. The method defines an asymmetrical dual gate structure which flanks a fin structure and is disposed approximately 90θ from the source/drain structure in the Si layer. The fin structure comprises an epitaxial SiGe/Si/SiGe sandwich which acts as a channel region.

After the formation of the fin structure and the gate electrodes, the source and drain regions are formed in a completing step.

Such a Double-Gate structure from the prior art has certain disadvantages.

Due to its layout the double gate structure has a current path which substantially resides in the sidewalls of the fin. This type of current path may result in a deterioration of the performance of the device unless extreme care is taken to ensure that a substantially perfect interface exists between the Si region, the side-walls and the dielectric region(s).

Also, depending on the orientation of the fin on the wafer, the current path lies in different crystallographic planes of Si, resulting in a different current drivability.

Moreover, the formation of the source/drain junctions may be complicated by the fact that high-angle implantations of dopants have to be used to reach the whole volume of the respective fin parts.

Furthermore, the height of the fin sets the absolute value of the current drive of the device (here the height acts similarly as a "width" dimension of a conventional MOSFET). Typically, in modem circuits the aspect ratio of the gate length to the width is as large as 10 (or even 20 for P-type devices), which means that for a gate length of 50 nm, the height of the fin would have to be about 500 nm.

At the same time the fin width (Si channel thickness between the gates) has to be smaller than 1/3 of the gate length, which for a 50 nm gate device of this example would imply a fin width of 16.5 nm. As is known to persons skilled in the art, the formation of the fin having a width of about 16 nm and a height of about 500 nm is not possible with current manufacturing capabilities (an aspect ratio between fin width and device height up to 5-6 seems reasonable, but a ratio of about 30 as described above in this example is not). A solution for this problem is believed to be the use of multiple fins for a device, however, this requires some significant issues to be resolved: all fins have to be exactly the same, and they cannot be spaced densely since the formation of source/drain junctions as mentioned above requires sufficient distance to allow high-angle implantations to be performed.

In summary, the combination of all the factors mentioned above results in a very important limitation of the prior art. This limitation necessitates that most of the current circuit designs must be re-done completely. Ideally, one would want to have a multi-gate device which, at least from the point of view of a circuit designer, is exactly the same as a standard planar single gate device.

This implies that a planar device, with the Si channel sandwiched in between two gates, would be much more suitable. However, in fabricating such a double-gate device, there are two major issues that have to be overcome:
- alignment of the two gates to each other (if not, parasitic capacitances will have a serious effect on the speed of operation of the device),
- source/drain contacts are required to have the lowest possible resistance (otherwise the current drive will be significantly reduced) and a very steep/sharp interface to the channel (otherwise the short-channel effects will be pronounced).

A double gate thin film transistor using through-implantation is known from JP-A-2003/309267.

It is an object of the present invention to provide a method of fabricating source and drain contacts and a channel region which cancels out the limitations of the prior art.

The object is achieved by a method of forming a transistor structure according to the claims.

Advantageously, the method according to the present invention achieves the above-described goal of manufacturing a FET device as suggested above. From the perspective of circuit design there will be no need to change any design layouts.

Moreover, the present invention relates to a (MOS)FET fabricated in accordance with the method as described above.

Also other transistor structures such as bipolar devices may be fabricated in accordance with the method as described above.

Furthermore, the present invention relates to a semiconductor device comprising a FET transistor structure such as a MOSFET fabricated by the method as described above.

Below, the invention will be explained with reference to some drawings, which are intended for illustration purposes only and not to limit the scope of protection as defined in the accompanying claims.
Fig. 1 shows schematically a gate structure for a MOSFET according to the present invention;
Fig. 2 shows schematically a first processing stage for forming self-aligned source and drain regions for a MOSFET according to the present invention;
Fig. 3 shows schematically a second processing stage for forming self-aligned source and drain regions for a MOSFET according to the present invention;
Fig. 4 shows schematically a third processing stage for forming a channel region for a MOSFET according to the present invention;
Fig. 5a shows schematically a plane view of the channel region in a first embodiment;
Fig. 5b shows schematically a plane view of the channel region in a second embodiment; and
Fig. 5c shows schematically a plane view of the channel region in a third embodiment.

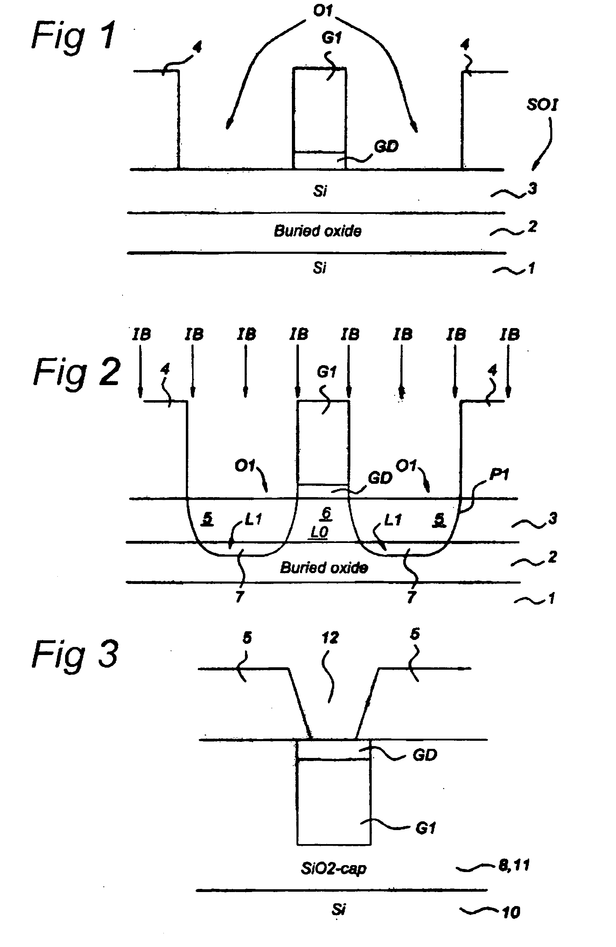

Figure 1 shows schematically a gate structure for a MOSFET according to the present invention.

The MOSFET structure is shown here as an illustration of the method according to the present invention for forming a transistor structure. Also a transistor structure like a bipolar device may be fabricated by this method. This will explained in more detail below.

The MOSFET to be formed by the method of the present invention is defined on a silicon-on-insulator (SOI) substrate, which comprises a supporting Si layer 1, a buried silicon dioxide layer 2, and a top Si layer 3. The top Si layer 3 is a doped layer, the dopant level being such as to enable the formation of good source/drain regions, e.g. 1×10²⁰-1×10²¹ cm⁻³. The gate of the MOSFET is to be formed on top of Si layer 3 of the SOI substrate.

In an initial processing stage a first gate structure G1 is defined above the top Si layer 3. The first gate G1 is electrically isolated from top Si layer 3 by a gate dielectric GD. The formation of the first gate G1 can be done by any suitable process known to a person skilled in the art.

An open area O1 of the top Si layer 3 is demarcated by an oxide layer or a resist layer 4, which is formed by any suitable process known to a skilled person.

The dimensions of the first gate G1 and the thickness of gate dielectric GD can be arbitrarily chosen in accordance with the application of the structure.

Figure 2 shows schematically a first processing stage for forming self-aligned source/drain regions for a MOSFET according to the present invention.

After definition of the gate structure G1, GD, and open regions 5, a "through the gate" ion implantation, denoted by arrows IB, is performed. The impurity species is chosen on the basis of its ability to allow (in a subsequent step) a selective removal of the implanted regions relative to the non-implanted regions. During this process, the gate G1 and the oxide or resist layer 4 act as implantation mask for the impurity species.

According to the present invention, the beam energy and dose of the ion beam IB provides for the formation of an impurity species concentration profile P1 with a high impurity level L0 in a region 6 of the top Si layer 3 below the gate structure G1, GD (and below the oxide or resist layer 4), and with a high impurity level L1 in the Buried Oxide layer regions 7 below the open regions 5. In the open regions 5 the impurity level is relatively low. The implantation with a high impurity level L0 can also cause heavy damage of the Si lattice in the region 6 of the top Si layer and even make it amorphous.

The high impurity level L0 in the region 6 below the gate dielectric GD and the high impurity level L1 below the open regions 5 may be up to the maximum solubility of the dopant species in Si.

The ion beam IB may comprise Ar, N, Ge, I, or Br as dopant species. Persons skilled in the art will appreciate which settings of beam energy and dose of the ion beam are required to generate the desired impurity concentration profile P1 with a high impurity level L1 in the buried oxide layer below open regions 5, and a high impurity level L0 in the region 6 below the gate structure G1, GD.

If needed for the selectivity of the (later) removal process, an annealing step may be done at this stage.

Figure 3 shows schematically a second processing stage for forming self-aligned source/drain regions for a MOSFET according to the present invention.

Firstly, the structure of open regions 5 and gate regions G1 is covered by a capping silicon-dioxide layer (SiO₂ cap) 8. The silicon-dioxide layer 8 is deposited by a suitable deposition process which does not in any way adversely affect the created open regions 5 and gate regions G1, GD.

Next, a second substrate 10, comprising a top silicon-dioxide layer (SiO₂)11, is bonded to the initial substrate SOI by a wafer bonding process known in the art. The top silicon-dioxide layer 11 of the second substrate 10 is arranged face-to-face on the surface of capping silicon-dioxide layer 8 of the substrate SOI.

In a further processing stage, the supporting silicon layer 1 and the buried silicon dioxide layer 2 of the substrate SOI are removed by a processing sequence of etching the supporting Si layer 1 and etching the buried silicon dioxide layer 2. The buried silicon dioxide layer 2 serves as a stop layer for the etching of the supporting silicon layer 1. The top Si layer 3 serves as a stop layer for the etching of the buried silicon dioxide layer 2. After this processing sequence, the top Si layer 3 is now the top layer of the second substrate 10. In this stage of the process according to the present invention, during etching of the buried silicon dioxide layer 2, all regions comprising a high impurity level, implanted by through-the-gate implantation, are simultaneously removed (in a selective mode relative to the non-implanted or low-level impurity regions G1).

In the second processing stage according to the present invention, the high level impurity region 6 is now removed by a selective etching process for silicon, which etching process provides specific etching of the high impurity level 6 under the G1 region. A high selectivity of this removal process ensures a substantially perfect alignment with the G1 region.

After removal of the high level impurity region 6, a gap 12 is formed in the Si layer between the open regions 5. Since the open regions 5 comprise dopant from the beginning (as top Si layer 3), the open regions 5 can act as source/drain regions 5.

It is known in the art that etching of a silicon layer by a given etchant can be specific depending on the presence and level of a specific impurity in the silicon layer. In the case of a monocrystalline Si layer, the specific etchant may even provide anisotropic etching, if required. Also, in the case of heavily damaged or amorphised Si, the boundary with crystalline Si can be used to ensure the selectivity.

Other low impurity level regions (in the first processing stage masked by oxide and /or resist layers 4) may at this stage be masked by a further oxide or resist layer mask (not shown) applied earlier.

It is noted that the gate dielectric GD may act as etch stop as well. Alternatively, the gate G1 may act as etch stop, in which case the etching process for the low level impurity region 6 removes the gate dielectric GD as well.

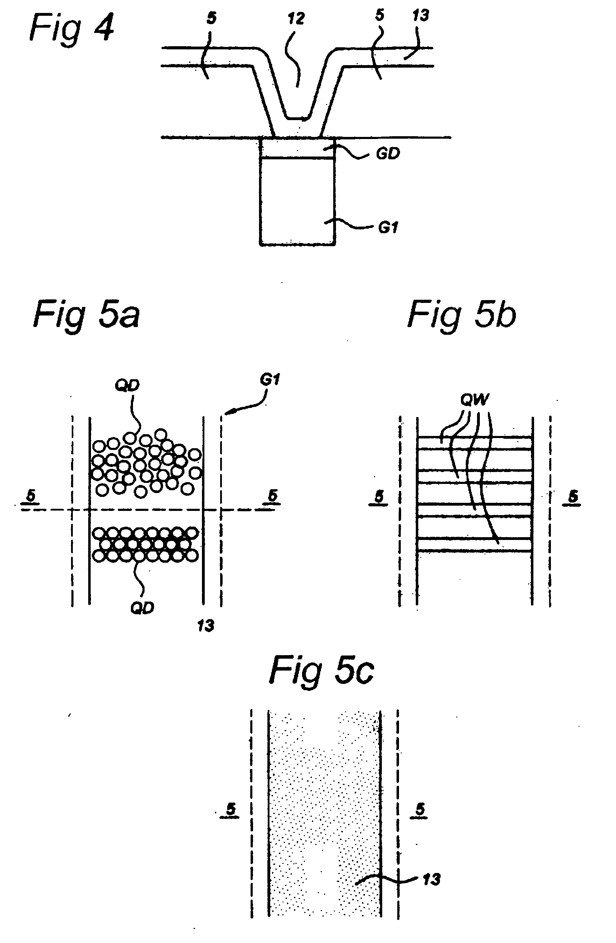

Figure 4 shows schematically a third processing stage for forming a channel region for a MOSFET according to the present invention.

In a third processing stage, in the gap 12 between source/drain regions 5 a channel layer 13 is formed by a suitable deposition or growth process.

The channel material for the channel layer 13 can be chosen almost arbitrarily. The channel material may be Si, SiGe, GaAs, InP and another III-V or II-VI compound, an intermetallic compound like a metal-disilicide (e.g., TiSi₂, CoSi₂) or even a very thin layer of any metal that can be depleted by an electric field present in the device (exact thickness can be easily determined and depends on the density of states of a given material), a metal, e.g., Al, Cu, W, Ag, Au, Pt, Co, Ni.

Moreover, the channel material may comprise quantum-wire QW or quantum-dot QD structures.

Furthermore, the channel material may comprise nano-wires, arrays of nano-dots, carbon nano-dots, nano-tubes, organic or bio-organic molecules like DNA or proteins.

The choice of the channel material is limited only by the requirement that an electrical contact between the channel material 13 and the source/drain regions 5 can be obtained during deposition or growth of the channel material.

Figures 5a, 5b, 5c show schematically a plane view of the channel region in a first, a second and a third embodiment, respectively.

Figures 5a, 5b and 5c show a plane view of a channel region 13, below which the gate G1, depicted by dashed lines, is located (and also, if not removed by the etching process for silicon mentioned above, the gate dielectric GD, not shown here). On one side of the channel region 13, a source region 5 is located, and on the other side a drain region 5 is located.

In Figure 5a a first embodiment is shown wherein a plurality of quantum-dots QD is arranged as channel layer 13 between source and drain. The quantum-dots may be ordered as an array (lower part of Figure 5a) or may be ordered in some random network (upper part of Figure 5a).

In Figure 5b a second embodiment is shown wherein a plurality of quantum-wires QW is arranged as channel layer 13 between source and drain regions 5. The quantum-wires QW are lengthwise arranged, with one end of the quantum-wire QW being in contact with the source region and the other end being in contact with the drain region.

In Figure 5c a third embodiment is shown wherein the channel layer 13 is a continuous medium between source/drain regions.

The embodiments as shown in Figures 4, 5a, 5b, 5c, may be further processed by suitable, known IC processing techniques for passivation, metallization and contacting to obtain a microelectronic device comprising a MOSFET structure according to one of the embodiments as described above.

It is noted that the transistor structure as described above may differ from a MOSFET; the gate region G1 may comprise Si, but may also consist of a metal.

Further, the gate dielectric may be a gate oxide but may also be a high-k material such as Si₃N₄.

Also, on top of the channel material 13, a second gate stack (not shown) may be formed in a further deposition process. Subsequently, processing techniques for passivation, metallization and contacting may be applied for creating a microelectronic device with a double gate structure.

Moreover, the structure of source, drain and channel regions 5, 13 may also be embodied in a bipolar transistor, wherein the gate G1 is arranged as an emitter, the channel region 13 is arranged as a collector, the gate dielectric GD is arranged as a base and the source/drain regions 5 are arranged as contacts to the base. In that case, the materials for emitter, collector, and base must be chosen in accordance with the bipolar transistor function of the device.

Finally, it is noted that during formation of the gap 12, the etching process is arranged so as to obtain smooth and abrupt interfaces between the source/drain regions 5 and the gap 12. After the formation of the gap 12, the thermal budget of all successive processing steps is preferably kept to a minimum in order to keep the shape of the interfaces as abrupt as possible and to allow the formation of abrupt junctions between source/drain regions and the channel layer 13.

## Claims

1. Method for forming a transistor structure on a substrate (SOI),
said substrate comprising a supporting Si layer (1), a buried insulating layer (2), and a top Si layer (3), said top Si layer (3) having a top layer thickness and comprising a high dopant level,
said transistor structure comprising a gate region (G1), and a source and drain region (5) in said top Si layer; said method comprising:
a formation of said gate region (G1) on said top Si layer (3), said gate region (G1) being separated from said top Si layer (3) by a dielectric layer (GD);
a formation of an open area (O1) on said top Si layer (3) demarcated by a demarcating oxide and/or resist layer region (4);
a formation of high level impurity or heavily-damaged regions by ion implantation, exposing said open area (O1) to an ion beam (IB) with said demarcating layer region (4) and said gate region (G1) acting as implantation mask, wherein said ion beam (IB) comprises a combination of a beam energy and a dose, which allows formation of high impurity level regions (L1) below said source and drain regions (5) in said buried insulating layer (2) and of a high impurity level or heavily-damaged region (L0) below said gate region (G1) in said top Si layer (3) and of low impurity level regions in said source and drain region, wherein said method also comprises:
a removal process of said high impurity level region (L0) of said top Si layer (3) below said gate region (G1) by selective etching with the use of said source and drain regions (5) as a stopping layer for said removal process, said removal process creating a gap (12) in between said source and drain regions (5), and a step of deposition of a channel layer (13) in said gap (12) to form a channel region.

2. Method for forming a transistor structure according to claim 1, wherein
said method comprises:
formation of a silicon dioxide capping layer (8);
wafer bonding said substrate (SOI) to a second substrate (10), said second substrate (10) comprising a silicon dioxide top layer (11), said capping layer (8) being face-to-face with said silicon dioxide top layer (11).

3. Method for forming a transistor structure according to claim 1 or 2, wherein said method comprises:
an initial removal process of said Si support layer (1) with the use of said buried insulating layer (2) as a stopping layer for said initial removal process;
a further removal process of said buried insulating layer (2) with the use of said top Si layer (3) as a stopping layer for said further removal process.

4. Method for forming a transistor structure according to claim 1, wherein
said method comprises:
the use of said dielectric region (GD) or said gate region (G1) as an additional stopping layer for said removal process.

5. Method for forming a transistor structure according to claim 1, wherein
said channel layer (13) comprises as channel material at least one of the following materials:
a semiconductor material as Si, SiGe, Ge, GaAs, or InP,
a III-V or II-VI compound,
a metal,
an intermetallic compound,
an organic or bio-organic compound.

6. Method for forming a transistor structure according to claim 1 or 5, wherein said channel layer (13) comprises a quantum wire (QW) or quantum dot (QD) structure.

7. Method for forming a transistor structure according to any of claims 1, or 5 or 6, wherein said channel layer (13) comprises nano-wires, an array of nano-dots, carbon nano-dots, or nano-tubes.

8. Method for forming a transistor structure according to any of the preceding claims, wherein said ion beam (IB) comprises ions of Ge, I, or Br.

9. Method for forming a transistor structure according to any of the preceding claims, wherein said transistor structure is a MOSFET structure.

## Patentansprüche

1. Verfahren zur Bildung einer Transistorstruktur auf einem Substrat (SOI), wobei das Substrat eine tragende Si-Schicht (1), eine vergrabene Isolierschicht (2) und eine obere Si-Schicht (3) umfasst, wobei die obere Si-Schicht (3) eine obere Schichtdicke hat und einen hohen Dotierungsmittelwert umfasst,
wobei die Transistorstruktur eine Gate-Region (G1) und eine Source- und Drain-Region (5) in der oberen Si-Schicht umfasst, wobei das Verfahren umfasst:
eine Bildung der Gate-Region (G1) auf der oberen Si-Schicht (3), wobei die Gate-Region (G1) von der oberen Si-Schicht (3) durch eine dielektrische Schicht (GD) getrennt ist;
eine Bildung einer offenen Fläche (O1) auf der oberen Si-Schicht (3), die durch eine abgrenzende Oxid- und/oder Resistschichtregion (4) abgegrenzt ist;
eine Bildung von Regionen mit hohem Störstellenniveau oder schwerer Beschädigung durch Ionenimplantation, wobei die offene Fläche (O1) einem Ionenstrahl (IB) ausgesetzt wird, während die abgrenzende Schichtregion (4) und die Gate-Region (G1) als Implantationsmaske dienen, wobei der Ionenstrahl (IB) eine Kombination aus einer Strahlenergie und einer Dosis umfasst, die die Bildung von Regionen mit hohem Störstellenniveau (L1) unter den Source- und Drain-Regionen (5) in der vergrabenen Isolierschicht (2) und einer Region mit hochgradigem Störstelleniveau oder schwerer Beschädigung (L0) unter der Gate-Region (G1) in der oberen Si-Schicht (3) und von Regionen mit geringem Störstellenniveau in der Source- und Drain-Region ermöglicht; wobei das Verfahren auch Folgendes umfasst:
einen Entfernungsprozess für die Region mit hohem Störstellenniveau (L0) der oberen Si-Schicht (3) unter der Gate-Region (G1) durch selektives Ätzen mit, Verwendung der Source- und Drain-Regionen (5) als Stoppschicht für den Entfernungsprozess, wobei der Entfernungsprozess eine Lücke (12) zwischen den Source- und Drain-Regionen (5) erzeugt, und einen Schritt zum Abscheiden einer Kanalschicht (13) in der Lücke (12) zur Bildung einer Kanalregion.

2. Verfahren zur Bildung einer Transistorstruktur nach Anspruch 1, wobei das Verfahren umfasst:
Bildung einer Siliziumdioxid-Abdeckschicht (8);
Wafer-Bindung des Substrats (SOI) an ein zweites Substrat (10), wobei das zweite Substrat (10) eine Siliziumdioxiddeckschicht (11) umfasst, wobei die Abdeckschicht (8) der Siliziumdioxiddeckschicht (11) zugewandt ist.

3. Verfahren zur Bildung einer Transistorstruktur nach Anspruch 1 oder 2, wobei das Verfahren umfasst:
einen anfänglichen Entfernungsprozess der Si-Trägerschicht (1) mit Verwendung der vergrabenen Isolierschicht (2) als Stoppschicht für den anfänglichen Entfernungsprozess;
einen weiteren Entfernungsprozess der vergrabenen Isolierschicht (2) mit Verwendung der oberen Si-Schicht (3) als Stoppschicht für den weiteren Entfernungsprozess.

4. Verfahren zur Bildung einer Transistorstruktur nach Anspruch 1, wobei das Verfahren umfasst:
die Verwendung der dielektrischen Region (GD) oder der Gate-Region (G1) als zusätzliche Stoppschicht für den Entfernungsprozess.

5. Verfahren zur Bildung einer Transistorstruktur nach Anspruch 1, wobei die Kanalschicht (13) als Kanalmaterial mindestens eines der folgenden Materialien umfasst:
ein Halbleitermaterial, wie Si, SiGe, Ge, GaAs oder InP,
eine III-V- oder II-VI-Verbindung,
ein Metall,
eine intermetallische Verbindung,
eine organische oder bioorganische Verbindung.

6. Verfahren zur Bildung einer Transistorstruktur nach Anspruch 1 oder 5, wobei die Kanalschicht (13) eine Quantendraht- (QW) oder Quantenpunkt- (QD) Struktur umfasst.

7. Verfahren zur Bildung einer Transistorstruktur nach einem der Ansprüche 1 oder 5 oder 6, wobei die Kanalschicht (13) Nanodrähte, eine Anordnung von Nanopunkten, Kohlenstoff-Nanopunkte oder Nanoröhren umfasst.

8. Verfahren zur Bildung einer Transistorstruktur nach einem der vorangehenden Ansprüche, wobei der Ionenstrahl (IB) Ionen von Ge, I oder Br umfasst.

9. Verfahren zur Bildung einer Transistorstruktur nach einem der vorangehenden Ansprüche, wobei die Transistorstruktur eine MOSFET-Struktur ist.

## Revendications

1. Procédé pour former une structure de transistor sur un substrat (SOI),
ledit substrat comprenant une couche de support en Si (1), une couche d'isolation enterrée (2), et une couche supérieure de Si (3), ladite couche supérieure de Si (3) ayant une épaisseur de couche supérieure et comprenant un niveau élevé d'impureté,
ladite structure de transistor comprenant une zone de grille (G1) et une zone de source et de drain (5) dans ladite couche supérieure de Si ; ledit procédé comprenant :
une formation de ladite zone de grille (G1) sur ladite couche' supérieure de Si (3), ladite zone de grille (G1) étant séparée de ladite couche supérieure de Si (3) par une couche diélectrique (GD) ;
une formation d'une surface ouverte (O1) sur ladite couche supérieure de Si (3) délimitée par un oxyde de délimitation et/ou une zone de couche de résist (4);
une formation de zones à niveau élevé d'impureté ou fortement endommagées par implantation ionique, exposant ladite surface ouverte (O1) à un faisceau d'ions (IB), ladite zone de couche de délimitation (4) et ladite zone de grille (G1) agissant en tant que masque d'implantation, dans lequel ledit faisceau d'ions (IB) comprend une combinaison d'une énergie et d'une dose de faisceau, ce qui permet la formation de zones de niveau élevé d'impureté (L1) au-dessous desdites zones de source et de drain (5) dans ladite couche d'isolation enterrée (2) et d'une zone de niveau élevé d'impureté ou fortement endommagée (L0) au-dessous de ladite zone de grille (G1) dans ladite couche supérieure de Si (3) et de zones de faible niveau d'impureté dans ladite zone de source et de drain, dans lequel ledit procédé comprend également :
un processus d'enlèvement de ladite zone de niveau élevé d'impureté (L0) de ladite couche supérieure de Si (3) au-dessous de ladite zone de grille (G1) par gravure sélective en utilisant lesdites zones de source et de drain (5) en tant que couche d'arrêt pour ledit processus d'enlèvement, ledit processus d'enlèvement créant un espacement (12) au milieu desdites zones de source et de drain (5), et une étape de dépôt, d'une couche de canal (13) dans ledit espacement (12) pour former une zone de canal.

2. procédé pour former une structure de transistor selon la revendication 1, dans lequel ledit procédé comprend :
la formation d'une couche de recouvrement en dioxyde de silicium (8) ;
la liaison sur plaquette dudit substrat (SOI) à un second substrat (10), ledit second substrat. (10) comprenant une couche supérieure de dioxyde de silicium (11), ladite couche de recouvrement (8) faisant face à ladite couche supérieure de dioxyde de silicium (11).

3. Procédé pour former une structure de transistor selon la revendication 1 ou 2, dans lequel ledit procédé comprend :
un processus d'enlèvement initial de ladite couche de support en Si (1) en utilisant ladite couche d'isolation enterrée (2) en tant que couche d'arrêt pour ledit processus d'enlèvement initial ;
un processus d'enlèvement supplémentaire de ladite couche d'isolation enterrée (2) en utilisant ladite couche supérieure de Si (3) en tant que couche d'arrêt pour ledit processus d'enlèvement supplémentaire.

4. Procédé pour former une structure de transistor selon la revendication 1, dans lequel ledit procédé comprend :
l'utilisation de ladite zone diélectrique (GD) ou de ladite zone de grille (G1) en tant que couche d'arrêt supplémentaire pour ledit processus d'enlèvement.

5. Procédé pour former une structure de transistor selon la revendication 1, dans lequel
ladite couche de canal (13) comprend en tant que matière de canal au moins;une des matières suivantes :
une matière semi-conductrice comme Si, SiGe, Ge, GaAs, ou InP,
un composé III-V ou II-VI,
un métal,
un composé intermétallique,
un composé organique ou bio-organique.

6. Procédé pour former une structure de transistor selon la revendication 1 ou 5, dans lequel ladite couche de canal (13) comprend une structure de fil quantique (QW) ou de point quantique (QD).

7. Procédé pour former une structure de transistor selon l'une quelconque des revendications 1, ou 5 ou 6, dans lequel ladite couche de canal (13) comprend des nanofils, un groupement de nanopoints, des nanopoints de carbone, ou des nanotubes..

8. Procédé pour former une structure de transistor selon l'une quelconque des revendications précédentes, dans lequel ledit faisceau d'ions (IB) comprend des ions de Ge, I, ou Br.

9. Procédé pour former une structure de transistor selon l'une quelconque des revendications précédentes, dans lequel ladite structure de transistor est une structure MOSFET.
